# EUROPEAN PATENT SPECIFICATION

(11) **EP 2 764 051 B1**
(45) Date of publication and mention of the grant of the patent: **24.10.2018**
(21) Application number: 12705740.4
(22) Date of filing: 09.02.2012
(51) Int. Cl.: C08L 83/04, C08K 5/00, H01L 21/56

(54) **GEL HAVING IMPROVED THERMAL STABILITY**
GEL MIT VERBESSERTER WÄRMESTABILITÄT
GEL AYANT UNE STABILITÉ THERMIQUE AMÉLIORÉE

(30) Priority: 06.10.2011 US 201161543985 P
(43) Date of publication of application: 13.08.2014
(73) Proprietor: Dow Silicones Corporation, Midland, MI 48686-0994 (US); Dow Corning Korea Ltd, Seoul 135-729 (KR)
(72) Inventor: BHAGWAGAR, Dorab, E., Saginaw, MI 48603 (US); HYUN, Daesup, Midland, Michigan 48642 (KR); MESSING, Kelly, J., Auburn, MI 48611 (US); LARSON, Kent, R., Midland, MI 48642 (US)
(74) Representative: Murgitroyd & Company
(86) International application number: PCT/US2012/024498
(87) International publication number: WO 2013/052147

(56) References cited:
- EP-A1- 0 426 137
- US-A- 2 723 964
- US-A1- 2004 092 655
- Acc Silicones Europe: "Product Sheet Silicone Gel", , 8 April 2010 (2010-04-08), XP55033469, Retrieved from the Internet: URL:http://www.acc-silicones.com/_assets/p dfs/applicationsheets/acc silicone gel product sheet.pdf [retrieved on 2012-07-20]

## Description

### FIELD OF THE DISCLOSURE

The present disclosure generally relates to a gel that is a hydrosilylation reaction product that has improved thermal stability and an electronic article including the gel.

### DESCRIPTION OF THE RELATED ART

Typical silicones have excellent stress-buffering properties, electrical properties, resistance to heat, and weather-proof properties and can be used in many applications. In many applications, silicones can be used to transfer heat away from heat-generating electronic components. However, when used in high performance electronic articles that include electrodes and small electrical wires, typical silicones tend to harden, become brittle, and crack, after exposure to long operating cycles and high heat. The hardening and cracking disrupt or destroy the electrodes and wires thereby causing electrical failure. Accordingly, there remains an opportunity to develop an improved silicone.

### SUMMARY OF THE DISCLOSURE AND ADVANTAGES

The instant disclosure provides a gel that has improved thermal stability. The gel is the hydrosilylation reaction product of (A) an organopolysiloxane having an average of at least 0.1 silicon-bonded alkenyl group per molecule and (B) a cross-linker having an average of at least 2 silicon-bonded hydrogen atoms per molecule. (A) and (B) react via hydrosilylation in the presence of (C) a hydrosilylation catalyst and (D) a phthalocyanine. The (D) phthalocyanine is present in an amount of from about 0.05 to about 30 weight percent based on a total weight of (A) and (B). (A) and (B) may optionally react with (E) a silicone fluid in the presence of (C) and (D). Alternatively, (A) and (B) optionally react in the presence of (C), (D), and (E). Furthermore, the gel has a hardness of less than about 1500 grams as measured after heat ageing at 225°C for 1000 hours that is calculated as a weight required to insert a TA-23 probe into the gel to a depth of 3 mm. This disclosure also provides an electronic article that includes an electronic component and the gel disposed on the electronic component.

The (D) phthalocyanine allows the gel to maintain low Young's modulus (i.e., low hardness and viscosity properties) even after extensive heat ageing. Young's modulus is referred to herein below simply as "modulus." A gel that maintains low modulus is less prone to hardening, becoming brittle, and cracking, after exposure to long operating cycles and high heat, decreasing the chance that, when used in an electronic article, any electrodes or wires will be damaged, thereby decreasing the chance that electrical failure will occur.

### DETAILED DESCRIPTION OF THE DISCLOSURE

The "Summary of the Disclosure and Advantage" and Abstract are incorporated here by reference.

The terminology "hydrosilylation reaction product" describes that (A) and (B) react via a hydrosilylation reaction in the presence of (C) and (D). Neither (C) nor (D) are consumed in the reaction (i.e., they are not reactants) but may participate in the reaction. In addition, (A) and (B) may optionally react with (E) a silicone fluid in the presence of (C) and (D). Alternatively, (A) and (B) optionally react in the presence of (C), (D), and (E). Even further, (E) may not be included or utilized at all. Each of (A), (B), (C), (D), and (E) are described in greater detail below.

### (A) Organopolysiloxane:

The (A) organopolysiloxane may be a single polymer or may include two or more polymers that differ in at least one of the following properties: structure, viscosity, average molecular weight, siloxane units, and sequence. The (A) organopolysiloxane has an average of at least 0.1 silicon-bonded alkenyl group per individual polymer molecule, i.e. there is, on average, at least one silicon-bonded alkenyl group per 10 individual polymer molecules. More typically, the (A) organopolysiloxane has an average of 1 or more silicon-bonded alkenyl groups per molecule. The (A) organopolysiloxane has an average of at least 2 silicon-bonded alkenyl groups per molecule. The (A) organopolysiloxane may have a molecular structure that is in linear form or branched linear form or in dendrite form. The (A) organopolysiloxane may be or may include a homopolymer, a copolymer, or a combination of two or more polymers. The (A) organopolysiloxane may be further defined as an organoalkylpolysiloxane.

The silicon-bonded alkenyl groups of the (A) organopolysiloxane are not particularly limited but typically are defined as one or more of vinyl, allyl, butenyl, pentenyl, hexenyl, or heptenyl groups. Each alkenyl group may be the same or different and each may be independently selected from all others. Each alkenyl group may be terminal or pendant. The (A) organopolysiloxane includes both terminal and pendant alkenyl groups.

The (A) organopolysiloxane may also include silicon-bonded organic groups including, but not limited to, monovalent organic groups free of aliphatic unsaturation. These monovalent organic groups may have at least one and as many as 2, 3, 4, 5, 6, 7, 8, 9, 10, 11, 12, 14, 16, 18, and 20 carbon atoms, and are exemplified by, but not limited to, alkyl groups such as methyl, ethyl, and isomers of propyl, butyl, t-butyl, pentyl, hexyl, heptyl, octyl, nonyl, decyl, undecyl, dodecyl, tetradecyl, hexadecyl, octadecyl, and eicosanyl; cycloalkyl groups such as cyclopentyl and cyclohexyl; and aromatic (aryl) groups such as phenyl, tolyl, xylyl, benzyl, and 2-phenylethyl; and 3,3,3,-trifluoropropyl, and similar halogenated alkyl groups. The organic groups are methyl or phenyl groups.

The (A) organopolysiloxane may also include terminal groups that may be further defined as alkyl or aryl groups as described above, and/or alkoxy groups exemplified by methoxy, ethoxy, or propoxy groups, or hydroxyl groups.

The (A) organopolysiloxane may have one of the following formulae:

Formula (I): R¹₂R²SiO(R¹₂SiO)_{d}(R¹R²SiO)ₑSiR¹₂R²,

Formula (II): R¹₃SiO(R¹₂SiO)_{f}(R¹R²SiO)_{g}SiR¹₃,

or combinations thereof.

In formulae (I) and (II), each R¹ is independently a monovalent organic group free of aliphatic unsaturation and each R² is independently an aliphatically unsaturated organic group. Suitable monovalent organic groups of R¹ include, but are not limited to, alkyl groups having 1 to 20, 1 to 15, 1 to 10, 5 to 20, 5 to 15, or 5 to 10 carbon atoms, e.g. methyl, ethyl, and isomers of propyl, butyl, t-butyl, pentyl, hexyl, heptyl, octyl, undecyl, and octadecyl; cycloalkyl groups such as cyclopentyl and cyclohexyl; and aryl groups such as phenyl, tolyl, xylyl, benzyl, and 2-phenylethyl. Each R² is independently an aliphatically unsaturated monovalent organic group, exemplified by alkenyl groups such as vinyl, allyl, butenyl, pentenyl, hexenyl, or heptenyl groups. It is also contemplated that R² may include halogen atoms or halogen groups.

Subscript "d" has an average value of at least 0.1, of at least 0.5, of at least 0.8, or of at least 2. Alternatively subscript "d" may have an average value of zero or an average value ranging from 0.1 to 2000. Subscript "e" may be 0 or a positive number. Further, subscript "e" may have an average value ranging from 0 to 2000. Subscript "f" may be 0 or a positive number. Further, subscript "f" may have an average value ranging from 0 to 2000. Subscript "g" has an average value of at least 0.1, of at least 0.5, of at least 0.8, or of at least 2. Alternatively, subscript "g" may have an average value ranging from 0.1 to 2000 or 1 to 2000.

The (A) organopolysiloxane is further defined as an alkenyldialkylsilyl end-blocked polydialkylsiloxane which may itself be further defined as vinyldimethylsilyl end-blocked polydimethylsiloxane. The (A) organopolysiloxane may be further defined as a dimethylpolysiloxane capped at one or both molecular terminals with dimethylvinylsiloxy groups; a dimethylpolysiloxane capped at one or both molecular terminals with methylphenylvinylsiloxy groups; a copolymer of a methylphenylsiloxane and a dimethylsiloxane capped at both one or both molecular terminals with dimethylvinylsiloxy groups; a copolymer of diphenylsiloxane and dimethylsiloxane capped at one or both molecular terminals with dimethylvinylsiloxy groups, a copolymer of a methylvinylsiloxane and a dimethylsiloxane capped at one or both molecular terminals with dimethylvinylsiloxy groups; a methyl (3,3,3-trifluoropropyl) polysiloxane capped at one or both molecular terminals with dimethylvinylsiloxy groups; a copolymer of a methyl (3,3,3-trifluoropropyl) siloxane and a dimethylsiloxane capped at one or both molecular terminals with dimethylvinylsiloxy groups; a copolymer of a methylvinylsiloxane and a dimethylsiloxane capped at one or both molecular terminals with silanol groups; a copolymer of a methylvinylsiloxane, a methylphenylsiloxane, and a dimethylsiloxane capped at one or both molecular terminals with silanol groups; or an organosiloxane copolymer composed of siloxane units represented by the following formulae: (CH₃)₃SiO_{½}, (CH₃)₂ (CH₂=CH)SiO_{½}, CH₃SiO_{3/2}, (CH₃)₂SiO_{2/2}, CH₃PhSiO_{2/2}, Ph₂SiO_{2/2}, and (CH₃)Ph(CH₂=CH)SiO_{1/2}.

The (A) organopolysiloxane may further include a resin such as an MQ resin defined as including, consisting essentially of, or consisting of R^{x}₃SiO_{1/2} units and SiO_{4/2} units, a TD resin defined as including, consisting essentially of, or consisting of R^{x}SiO_{3/2} units and R^{x}₂SiO_{2/2} units, an MT resin defined as including, consisting essentially of, or consisting of R^{x}₃SiO_{1/2} units and R^{x}SiO_{3/2} units, an MTD resin defined as including, consisting essentially of, or consisting of R^{x}₃SiO_{1/2} units, R^{x}SiO_{3/2} units, and R^{x}₂SiO_{2/2} units, or a combination thereof. R^{x} designates any monovalent organic group, for example but is not limited to, monovalent hydrocarbon groups and monovalent halogenated hydrocarbon groups. Monovalent hydrocarbon groups include, but are not limited to, alkyl groups having 1 to 20, 1 to 15, 1 to 10, 5 to 20, 5 to 15, or 5 to 10 carbon atoms such as methyl, ethyl, and isomers of propyl, butyl, t-butyl, pentyl, octyl, undecyl, and octadecyl; cycloalkyl groups such as cyclohexyl; alkenyl groups such as vinyl, allyl, butenyl, and hexenyl; alkynyl groups such as ethynyl, propynyl, and butynyl; and aryl groups such as phenyl, tolyl, xylyl, benzyl, and 2-phenylethyl. The (A) organopolysiloxane is free of halogen atoms. The (A) organopolysiloxane includes one or more halogen atoms.

### (B) Cross-Linker:

The (B) cross-linker has an average of at least 2 silicon-bonded hydrogen atoms per molecule and may be further defined as, or include, a silane or a siloxane, such as a polyorganosiloxane. The (B) cross-linker may include 2, 3, or even more than 3, silicon-bonded hydrogen atoms per molecule. The (B) cross-linker may have a linear, branched, or partially branched linear, cyclic, dendrite, or resinous molecular structure. The silicon-bonded hydrogen atoms may be terminal or pendant. Alternatively, the (B) cross-linker may include both terminal and pendant silicon-bonded hydrogen atoms.

In addition to the silicon-bonded hydrogen atoms, the (B) cross-linker may also include monovalent hydrocarbon groups which do not contain unsaturated aliphatic bonds, such as methyl, ethyl, and isomers of propyl, butyl, t-butyl, pentyl, hexyl, heptyl, octyl, decyl, undecyl, dodecyl, or similar alkyl groups, e.g., alkyl groups having 1 to 20, 1 to 15, 1 to 10, 5 to 20, 5 to 15, or 5 to 10 carbon atom; cyclopentyl, cyclohexyl, or similar cycloalkyl groups; phenyl, tolyl, xylyl, or similar aryl groups; benzyl, phenethyl, or similar aralkyl groups; or 3,3,3- trifluoropropyl, 3-chloropropyl, or similar halogenated alkyl group. Preferable are alkyl and aryl groups, in particular, methyl and phenyl groups.

The (B) cross-linker may also include siloxane units including, but not limited to, HR³₂SiO_{1/2}, R³₃SiO_{1/2}, HR³SiO_{2/2}, R³₂SiO_{2/2}, R³SiO_{3/2}, and SiO_{4/2} units. In the preceding formulae, each R³ is independently selected from monovalent organic groups free of aliphatic unsaturation. The (B) cross-linker includes or is a compound of the formulae:

Formula (III) R³₃SiO(R³₂SiO)ₕ(R³HSiO)ᵢSiR³₃,

Formula (IV) R³₂HSiO(R³₂SiO)ⱼ(R³HSiO)ₖSiR³₂H,

or a combination thereof.

In formulae (III) and (IV) above, subscript "h" has an average value ranging from 0 to 2000, subscript "i" has an average value ranging from 2 to 2000, subscript "j" has an average value ranging from 0 to 2000, and subscript "k" has an average value ranging from 0 to 2000. Each R³ is independently a monovalent organic group. Suitable monovalent organic groups include alkyl groups having 1 to 20, 1 to 15, 1 to 10, 5 to 20, 5 to 15, or 5 to 10 carbon atoms, such as methyl, ethyl, and isomers of propyl, butyl, t-butyl, pentyl, octyl, decyl, undecyl, dodecyl, and octadecyl; cycloalkyl such as cyclopentyl and cyclohexyl; alkenyl such as vinyl, allyl, butenyl, and hexenyl; alkynyl such as ethynyl, propynyl, and butynyl; and aryl such as phenyl, tolyl, xylyl, benzyl, and 2-phenylethyl.

The (B) cross-linker may alternatively be further defined as a methylhydrogen polysiloxane capped at both molecular terminals with trimethylsiloxy groups; a copolymer of a methylhydrogensiloxane and a dimethylsiloxane capped at both molecular terminals with trimethylsiloxy groups; a dimethylpolysiloxane capped at one or both molecular terminals with dimethylhydrogensiloxy groups; a methylhydrogenpolysiloxane capped at one or both molecular terminals with dimethylhydrogensiloxy groups; a copolymer of a methylhydrogensiloxane and a dimethylsiloxane capped at one or both molecular terminals with dimethylhydrogensiloxy groups; a cyclic methylhydrogenpolysiloxane; and/or an organosiloxane composed of siloxane units represented by the following formulae: (CH₃)₃ SiO_{½}, (CH₃)₂HSiO_{½}, and SiO_{4/2}; tetra(dimethylhydrogensiloxy) silane, or methyl-tri(dimethylhydrogensiloxy) silane.

It is also contemplated that the (B) cross-linker may be or include a combination of two or more organohydrogenpolysiloxanes that differ in at least one of the following properties: structure, average molecular weight, viscosity, siloxane units, and sequence. The (B) cross-linker may also include a silane. Dimethylhydrogensiloxy-terminated poly dimethylsiloxanes having relatively low degrees of polymerization (DP) (e.g., DP ranging from 3 to 100) are commonly referred to as chain extenders, and a portion of the (B) cross-linker may be or include a chain extender. The (B) cross-linker is free of halogen atoms. The (B) cross-linker includes one or more halogen atoms per molecule.. It is contemplated that the gel, as a whole, may be free of halogen atoms or may include halogen atoms.

### (C) Hydrosilylation Catalyst:

The (C) hydrosilylation catalyst is not particularly limited and may be any known in the art. In one embodiment, the (C) hydrosilylation catalyst includes a platinum group metal selected from platinum, rhodium, ruthenium, palladium, osmium or iridium, organometallic compounds thereof, or combinations thereof. In another embodiment, the (C) hydrosilylation catalyst is further defined as a fine platinum metal powder, platinum black, platinum dichloride, platinum tetrachloride; chloroplatinic acid, alcohol-modified chloroplatinic acid, chloroplatinic acid hexahydrate; and complexes of such compounds, such as platinum complexes of olefins, platinum complexes of carbonyls, platinum complexes of alkenylsiloxanes, e.g. 1,3-divinyltetramethyldisiloxane, platinum complexes of low molecular weight organopolysiloxanes, for example 1,3-diethenyl-1,1,3,3 -tetramethyldisiloxane, complexes of chloroplatinic acid with β-diketones, complexes of chloroplatinic acid with olefins, and complexes of chloroplatinic acid with 1,3-divinyltetramethyldisiloxane.

Alternatively, the (C) hydrosilylation catalyst may be further defined as a rhodium compound, such as those expressed by formulae: RhX₃[(R⁴)₂S]₃; (R⁵₃P)₂Rh(CO)X, (R⁵₃P)₂Rh(CO)H, Rh₂X₂Y₄, H_{f}Rh_{g}(En)ₕClᵢ, or Rh[O(CO)R]₃-ⱼ (OH)ⱼ, wherein each X is independently a hydrogen atom, chlorine atom, bromine atom, or iodine atom, each Y is independently a methyl group, ethyl group, or a similar alkyl group, CO, C₈H₁₄, or 0.5 C₈H₁₂; each R⁴ is independently a methyl, ethyl, propyl, or a similar alkyl group; a cycloheptyl, cyclohexyl, cyclopentyl, or a similar cycloalkyl group; or a phenyl, xylyl or a similar aryl group; each R⁵ is independently a methyl group, ethyl group, or a similar alkyl group; phenyl, tolyl, xylyl, or a similar aryl group; methoxy, ethoxy, or a similar alkoxy group, wherein each "En" is ethylene, propylene, butene, hexene, or a similar olefin; subscript "f" is 0 or 1; subscript "g" is 1 or 2; subscript "h" is an integer from 1 to 4; subscript "i" is 2, 3, or 4; and subscript "j" is 0 or 1. Particularly suitable but non-limiting examples of rhodium compounds are RhCl(Ph₃P)₃, RhCl₃[S(C₄H₉)₂]₃, [Rh(O₂CCH₃)₂]₂, Rh(OCCH₃)₃, Rh₂(C₈H₁₅O₂)₄, Rh(C₅H₇O₂)₃, Rh(C₅H₇O₂)(CO)₂, and Rh(CO)[Ph₃P](C₅H₇O₂).

The (C) hydrosilylation catalyst may also be further defined as an iridium group compound represented by the following formulae: Ir(OOCCH₃)₃, Ir(C₅H₇O₂)₃, [Ir(Z)(En)₂]₂, or [Ir(Z)(Dien)]₂ wherein each "Z" is chlorine atom, bromine atom, iodine atom, or a methoxy group, ethoxy group, or a similar alkoxy group; each "En" is ethylene, propylene, butene, hexene, or a similar olefin; and "Dien" is (cyclooctadiene)tetrakis(triphenyl). The (C) hydrosilylation catalyst may also be palladium, a mixture of palladium black and triphenylphosphine.

The (C) hydrosilylation catalyst and/or any of the aforementioned compounds may be microencapsulated in a resin or wax matrix or coreshell type structure, or may be mixed and embedded in an thermoplastic organic resin powder, e.g. a methylmethacrylate resin, carbonate resin, polystyrene resin, silicone resin, or similar resin. Typically, the (C) hydrosilylation catalyst is present/utilized in an amount of from 0.01 to 1,000 ppm, alternatively 0.1 to 500 ppm alternatively 1 to 500 ppm, alternatively 2 to 200, alternatively 5 to 150 ppm, based on the total weight of (A) and (B).

### (D) Phthalocyanine:

The (D) phthalocyanine may include a metal or may be free of a metal. Alternatively, more than one phthalocyanine may be utilized wherein a first phthalocyanine includes a metal and a second phthalocyanine is free of a metal. Suitable but non-limiting examples of the (D) phthalocyanine of this disclosure are represented by the chemical structure set forth below wherein each X is independently a hydrogen or halogen atom, e.g., chlorine, bromine, and iodine

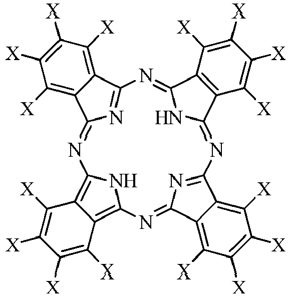

Alternatively, X may be further defined as an R group, i.e., an organic group such as an aliphatic or aromatic group. The (D) phthalocyanine is further defined as having the following structure and is known in the art as 29H, 31H-phthalocyanine:

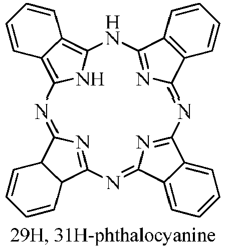

Alternatively, the (D) phthalocyanine can include a metal and may have a structure similar to the structure below: 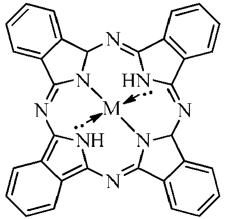 wherein M is a metal such as a transition metal, a metal selected from the group consisting of iron, magnesium, cobalt, and copper, or a metal selected from the group consisting of copper, nickel, cobalt, iron, chromium, zinc, platinum, and vanadium and the lone pair electrons of the nitrogen atoms form coordinate bonds with the metal. M is a metal is selected from the group consisting of iron, magnesium, cobalt, and copper.

Alternatively, the (D) phthalocyanine may be selected from the group consisting of 29H, 31H-phthalocyaninato (2-)-N29, N30, N31, N32 Iron; 29H, 31H-phthalocyaninato (2-)-N29, N30, N31, N32 Magnesium; 29H, 31H-phthalocyaninato (2-)-N29, N30, N31, N32 Cobalt, and 29H, 31H-phthalocyaninato (2-)-N29, N30, N31, N32 Copper. Alternatively, the (D) phthalocyanine may be further defined as a halogen salt, e.g. as a metal phthalocyanine chloride, bromide, or iodide. A non-limiting structure of a copper halogen salt is set forth below:

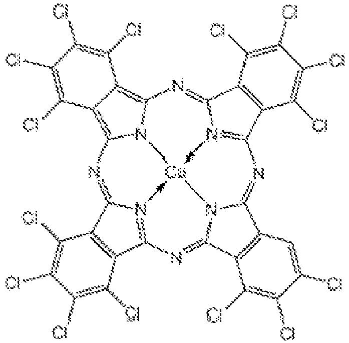

The (D) phthalocyanine typically has a particle size of from about 0.05 to about 10 µm, from about 0.05 to about 5 µm, from about 0.05 to about 3 µm, or from about 0.5 to 1.6 µm. The particle size is as set forth below ± 5%, ± 10%, ± 15%, ± 20%, ± 25%, ± 30%, etc.

**TABLE 1**

| Volume % of Particles | Size of Particles (µm) |
|---|---|
| 10 | .620 |
| 20 | .698 |
| 30 | .762 |
| 40 | .823 |
| 50 | .887 |
| 60 | .960 |
| 70 | 1.051 |
| 80 | 1.173 |
| 90 | 1.368 |
| 100 | 1.560 |

The (D) phthalocyanine is present in an amount of from about 0.05 to about 30 weight percent based on a total weight of (A) and (B). It is alternatively contemplated that the (D) phthalocyanine may be present in an amount of from about 0.05 to about 5, about 0.1 to about 5, about 0.1 to about 1, about 0.05 to about 1, about 0.1 to 2, about 1 to about 5, about 2 to about 4, about 2 to about 3, about 5 to about 25, about 10 to about 20, or about 15 to about 20, weight percent based on a total weight of (A) and (B).

It is also contemplated that the (D) phthalocyanine itself, and/or the gel as a whole, may have a concentration of metal, such as copper or any other metal described above, of greater than 1,000, 1,500, 2,500, 5,000, 7,500, 10,000, 12,500, 15,000, 17,500, 20,000, 25,000, 30,000, 35,000, 40,000, 45,000, 50,000, 55,000 or even higher, parts by weight of metal per one million parts by weight of the (D) phthalocyanine and/or the gel itself. The (D) phthalocyanine and/or the gel has a concentration of metal greater than about 30,000 ppm. The (D) phthalocyanine and/or the gel has a concentration of metal greater than about 40,000 ppm.

### (E) Silicone Fluid:

The gel may also be formed utilizing (E) a silicone fluid. The (E) silicone fluid may be alternatively described as only one of, or as a mixture of, a functional silicone fluid and/or a non-functional silicone fluid. (E) is further defined as a polydimethylsiloxane, which is not functional. (E) is further defined as a vinyl functional polydimethylsiloxane. The terminology "functional silicone fluid" typically describes that the fluid is functionalized to react in a hydrosilylation reaction, i.e., include unsaturated groups and/or Si-H groups. However, it is contemplated that the fluid may include one or more additional functional groups in addition to, or in the absence of, one or more unsaturated and/or Si-H groups. In various non-limiting embodiments, (E) is as described in one or more of U.S. Pat. Nos. 6,020,409; 4,374,967; and/or 6,001,918, (E) is not particularly limited to any structure or viscosity.

As first described above, (E) may or may not participate as a reactant with (A) and (B) in a hydrosilylation reaction. (E) is a functional silicone fluid and reacts with (A) and/or (B) in the presence of (C) and (D). Said differently, the hydrosilylation reaction product may be further defined as the hydrosilylation reaction product of (A), (B), and (E) the functional silicone fluid wherein (A), (B), and (E) react via hydrosilylation in the presence of (C) and (D). (A) and (B) react via hydrosilylation in the presence of (C), (D), and (E) a non-functional silicone fluid. Alternatively, (E) may not be utilized at all.

One or more of (A)-(E) may be combined together to form a mixture and the mixture may further react with remaining components of (A) - (E) to form the gel, with (E) being an optional component in either the mixture or as a remaining component. In other words, any combination of one or more (A)-(E) may react with any other combination of one or more of (A)-(E) so long as the gel is formed.

It is alternatively contemplated that one or more of the instant (A) organopolysiloxane, the (B) cross-linker, the (C) hydrosilylation catalyst, and/or the (D) phthalocyanine may be as described in U.S. Prov. App. Ser. No. 61/436,214, filed on January 26, 2011.

### Optional Additives:

Any one or more of (A)-(E), or a mixture comprising two or more of (A)-(E),may be independently combined with one or more additives including, but not limited to, pigments (e.g. black pigment), inhibitors, spacers, electricity- and/or heat-conducting and/or non-conducting fillers, reinforcing and/or non-reinforcing fillers, filler treating agents, adhesion promoters, solvents or diluents, surfactants, flux agents, acid acceptors, hydrosilylation stabilizers, stabilizers such as heat stabilizers and/or UV stabilizers, UV sensitizers, flame retardants, and the like. Black pigment is utilized to hide a color change after heat ageing. Examples of the aforementioned additives are described in U.S. Prov. App. Ser. No. 61/436,214, filed on January 26, 2011. It is also contemplated that one of more of (A)-(C) or any one or more of the additives may be as described in PCT/US2009/039588. It is also contemplated that the gel and/or the electronic article of this disclosure may be free of one or more of any of the aforementioned additives. Gel:

The hardness is measured and calculated as described below using a TA-23 probe. The gel has a hardness of less than about 1500 grams as measured after heat ageing at 225°C for 1000 hours. The gel has a hardness of less than about 1500 grams as measured after heat ageing at 225°C for 500 hours. The gel has a hardness of less than 1400, 1300, 1200, 1100, 1000, 900, 800, 700, 600, 500, 400, 300, 200, 100, 90, 80, 70, 60, 50, 40, 30, or 20, grams as measured after heat ageing at 225°C or 250°C for 250 hours, for 500 hours, or for 1000 hours. The gel has a hardness of less than 105, less than 100, less than 95, less than 90, less than 85, less than 80, less than 75, less than 70, less than 65, less than 60, less than 55, less than 50, less than 45, less than 40, less than 35, less than 30, less than 25, or less than 20, grams, as measured after heat ageing at 225°C for 500 hours. It is also contemplated that the hardness of the gel can be measured using different, but similar, heat ageing times and temperatures. Contrary to traditional wisdom, the hardness of the gel typically initially decreases after heat ageing. It is contemplated that the hardness of the gel may remain lower after heat ageing than before or may eventually increase to a hardness that is greater, but typically only after long periods of time. These hardness values vary by ± 5%, ± 10%, ± 15%, ± 20%, ± 25%, ± 30%, etc.

The hardness is calculated as the weight required to insert a TA-23 probe into the gel to a depth of 3 mm. More specifically, the method used to calculate hardness utilizes a Universal TA.XT2 Texture Analyzer (commercially available from Texture Technologies Corp., of Scaresdale, NY) or its equivalent and a TA-23 (0.5 inch round) probe. The Texture Analyzer has a force capacity of 55 lbs and moves the probe at a speed of 1.0 mm/s. The Trigger Value is 5 grams, the Option is set to repeat until count and to set count to 5, the Test Output is Peak, the force is measured in compression, and the container is a 4 oz wide-mouth, round glass bottle. All measurements are made at 25°C ± 5°C and 50% ± 4% relative humidity. Even more specifically, samples of the gel are prepared, cured, cooled to room temperature (25°C ± 5°C), and stabilized at room temperature for at least 0.5 hours, for 2 to 3 hours, or until a stable hardness is reached. The sample is then positioned on the test bed directly under the probe. The Universal TA.XT2 Texture Analyzer is then programmed with the aforementioned specific parameters according to the manufacturer's operating instructions. Five independent measurements are taken at different points on the surface of the gel. The median of the five independent measurements are reported. The test probe is wiped clean with a soft paper towel after each measurement is taken. The repeatability of the value reported (i.e., the maximum difference between two independent results) should not exceed 6 g at a 95% confidence level. Typically, the thickness of the sample is sufficient to ensure that when the sample is compressed, the force measurement is not influenced by the bottom of the bottle or the surface of the test bed. When performing measurements, the probe is typically not within 0.5 inch of the side of the sample.

It is also contemplated that the gel may have a penetration value, as determined by the JIS K 2220 (1/4 cone) method or ASTM D1403, of greater than or equal to about 20 as measured after heat ageing at 225°C for 1000 hours. The gel has a penetration value of from 20 to 200, from 40 to 120, or from 20 to 30, as determined by the JIS K 2220 (1/4 cone) method or ASTM D1403, after heat ageing at 225°C for 1000 hours.

The combination of (A) to (D), and optionally (E), before reaction to form the gel, typically has a viscosity less than about 100,000, 75,000, 50,000, 25,000, or 10,000, cps measured at 25°C using a Brookfield DV-II+ cone and plate viscometer using spindles appropriate for viscosity, e.g. spindle CP-52 at 50 rpm. The combination of (A) to (D), (and optionally (E)) before reaction to form the gel, has a viscosity of less than 9,500, less than 9,000, less than 8,500, less than 8,000, less than 7,500, less than 7,000, less than 6,500, less than 6,000, less than 5,500, less than 5,000, less than 4,500, less than 4,000, less than 3,500, less than 3,000, less than 2,500, less than 2,000, less than 1,500, less than 1,000, less than 500, less than 400, less than 300, less than 200, less than 100, less than 90, less than 80, less than 70, less than 60, less than 50, less than 40, less than 30, less than 20, or less than 10, cps measured at 25°C using a Brookfield DV-II+ cone and plate viscometer with spindles appropriate for viscosity, e.g. spindle CP-52 at 50 rpm.

The disclosure also provides a method of forming the gel. The method may include the steps of providing the (A) organopolysiloxane, the (B) cross-linker, the (C) hydrosilylation catalyst, and the (D) phthalocyanine (and/or (E)), and the steps of combining one or more of (A)-(D) (and optionally (E)) together. The method may also include the steps of curing or partially curing, via a hydrosilylation reaction, (A) and (B), in the presence of (C) and (D) and optionally (E). It is also contemplated that (A) and (B) may react with or cure with or in the presence of one of more of the aforementioned additives or other monomers or polymers described above.

Typically, (A) and (B) are present (or (A), (B), and inhibitor, and optionally (E)), and/or reacted, in an amount such that a ratio of silicon-bonded hydrogen atoms to silicon-bonded alkenyl groups is less than about 1.3:1. Alternatively, the ratio may be about 1:1 or less than about 1:1. The ratio is less than 0.9:1, 0.8:1, 0.7:1, 0.6:1, or 0.5:1.

The gel has a hardness of less than 40 grams that initially decreases after heat ageing, the phthalocyanine is present in an amount of from 0.1 to 2 weight percent based on a total weight of (A) and (B) and includes a metal selected from the group consisting of iron, magnesium, cobalt, and copper, and (A) and (B) are present in an amount such that a ratio of silicon-bonded hydrogen atoms to silicon-bonded alkenyl groups is less than about 1.3:1.

### Electronic Article:

The instant disclosure also provides an electronic article (hereinafter referred to as an "article.") The article may be a power electronic article. The article includes an electronic component and the gel disposed on the electronic component. The gel may be disposed on the electronic component such that the gel encapsulates, either partially or completely, the electronic component. Alternatively, the electronic article may include the electronic component and a first layer. The gel may be sandwiched between the electronic component and the first layer, may be disposed on and in direct contact with the first layer, and/or on and in direct contact with the electronic component. If the gel is disposed on and in direct contact with the first layer, the gel may still be disposed on the electronic component but may include one or more layers or structures between the gel and the electronic component. The gel may be disposed on the electronic component as a flat member, a hemispherical nubbin, a convex member, a pyramid, and/or a cone. The electronic component may be further defined as a chip, such as a silicon chip, GaN chip, or a silicon carbide chip, one or more wires, one or more sensors, one or more electrodes, and the like.

The electronic article is not particularly limited and may be further defined as an insulated gate bipolar transistor (IGBT), a rectifier such as a Schottky diode, a PiN diode, a merged PiN/Schottky (MPS) rectifier and Junction barrier diode, a bipolar junction transistors (BJTs), a thyristor, a metal oxide field effect transistor (MOSFET), a high electron mobility transistor (HEMT), a static induction transistors (SIT), a power transistor, and the like. The electronic article can alternatively be further defined as power modules including one of more of the aforementioned devices for power converters, inverters, boosters, traction controls, industrial motor controls, power distribution and transportation systems. The electronic article can alternatively be further defined as including one or more of the aforementioned devices.

In addition, the first layer is not particularly limited and may be further independently defined as a semiconductor, a dielectric, metal, plastic, carbon fiber mesh, metal foil, a perforated metal foil (mesh), a filled or unfilled plastic film (such as a polyamide sheet, a polyimide sheet, polyethylene naphthalate sheet, a polyethylene terephthalate polyester sheet, a polysulfone sheet, a polyether imide sheet, or a polyphenylene sulfide sheet), or a woven or nonwoven substrate (such as fiberglass cloth, fiberglass mesh, or aramid paper). Alternatively, the first layer may be further defined as a semiconductor and/or dielectric film.

The disclosure also provides a method of forming the electronic article. The method may include one or more of the aforementioned steps of forming the gel, the step of providing the gel, and/or the step of providing the electronic component.. Alternatively, the gel may be formed apart from the electronic component and subsequently be disposed on the electronic component.

### EXAMPLES

A series of gels (Gels 1-10) are formed according to this disclosure. Two comparative gels (Comparative Gel 1 and 2) are also formed but do not include the phthalocyanine of this disclosure. Each of the Gels 1-10 and the Comparative Gels 1 and 2 is evaluated to determine initial hardness, hardness after heat ageing, and viscosity.

The compositions used to form each of the Gels and the results of the aforementioned evaluations are shown in Table 2 below. More specifically, equal weight parts of Part A and Part B are mixed and de-aired to form a mixture. The mixture is then poured into an aluminum cup and cured at 150°C for one hour to form the Gels. Subsequently, the Gels are cooled and initial hardness and viscosity are measured, pursuant to the methods described in detail above. Then, the Gels are heat aged and again evaluated for hardness after heat ageing at 225°C for 1000 hours. In Table 2, all weight percentages set forth in Part A are based on a total weight of Part A. All weight percentages set forth in Part B are based on a total weight of Part B. The values for gel hardness set forth in all tests below represent the average (mean) of 5 independent measurements of the respective Gel.

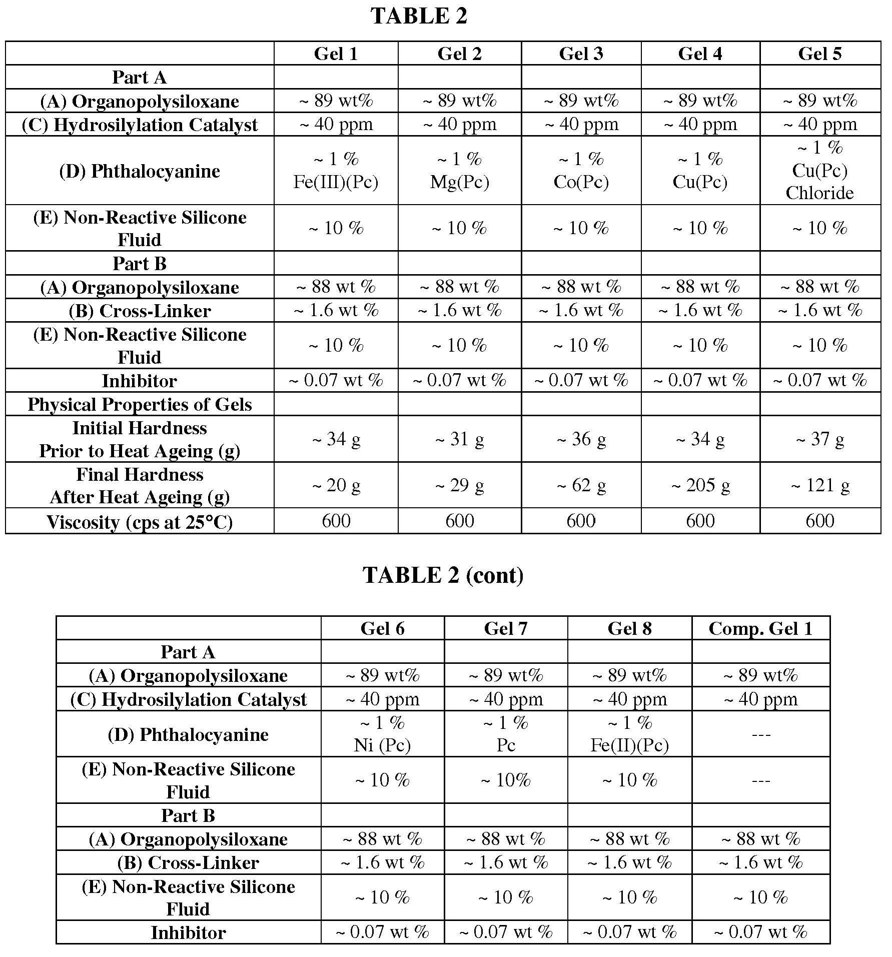

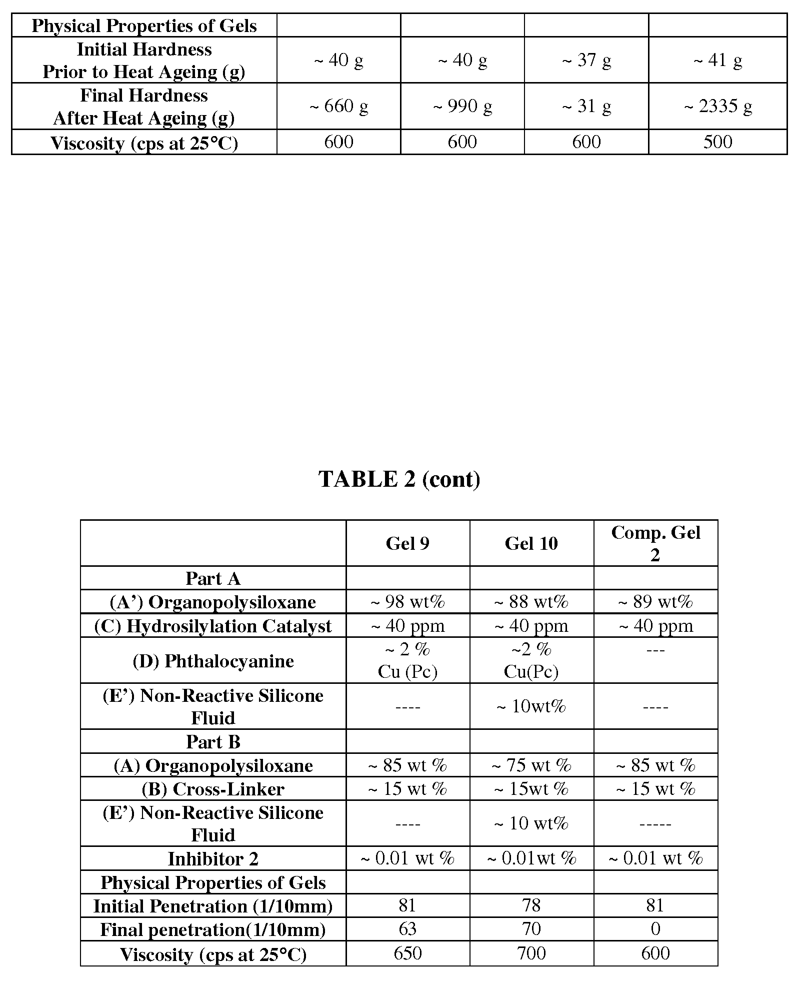

The (A) Organopolysiloxane is a dimethylvinylsiloxy terminated polydimethylsiloxane.

The (A') Organopolysiloxane is dimethylsiloxane with methyl silsesquioxane, trimethyl term and dimethylvinylsiloxy-termination.

The (B) Cross-Linker is a trimethylsiloxy terminated dimethylmethylhydrogen siloxane.

The (B') Cross-Linker is a dimethylhydrogensiloxy terminated dimethylsiloxane.

The (C) Hydrosilylation Catalyst is a 1,3-divinyltetrmethyl disiloxane complex of platinum.

The (D) Phthalocyanine is as follows:

Fe(Pc) is iron phthalocyanine, which has a chemical formula C₃₂H₁₆FeN₈, and a CAS Registry number of 132-16-1.

Mg(Pc) is magnesium phthalocyanine, which has a chemical formula C₃₂H₁₆MgN₈, and a CAS Registry number of 1661-03-6.

Co(Pc) is cobalt phthalocyanine, which has a chemical formula C₃₂H₁₆CoN₈, and a CAS Registry number of 3317-67-7.

Cu(Pc) is copper phthalocyanine, which has a chemical formula C₃₂H₁₆CuN₈, and a CAS Registry number of 147-14-8.

Cu(Pc) Chloride is copper phthalocyanine chloride, which has a chemical formula C₃₂HCl₁₅CuN₈, and a CAS Registry number of 1328-53-6.

Ni(Pc) is nickel phthalocyanine, which has a chemical formula C₃₂H₁₆NiN₈, and a CAS Registry number of 14055-02-8 .

(Pc) is phthalocyanine, which has a chemical formula C₃₂H₁₈N₈, and a CAS Registry number of 574-93-6.

Zn(Pc) is zinc phthalocyanine, which has a chemical formula C₃₂H₁₆ZnN₈, and a CAS Registry number of 14320-04-8.

The (E) Non-Reactive Silicone Fluid is Dow Corning 200F silicone fluid.

The (E') Non-Reactive Silicone Fluid is Dow Corning 510 silicone fluid.

The Inhibitor is tetramethyl tetravinyl cyclotetra siloxane.

The Inhibitor 2 is tetramethyl ethylene diamine.

The data in Table 2 clearly establishes that the gels of this disclosure outperform the Comparative Gels 1 and 2 relative to hardness after heat ageing. More specifically, the phthalocyanine in Gels 1-10 allows these gels to maintain low modulus properties even after extensive heat ageing.

### Additional Gel Evaluation:

Additional samples of Gel 4 are further evaluated to determine repeatability of the heat ageing and hardness data developed pursuant to the tests described in detail above. In a first group, samples of Gel 4 are heat aged for 0, 70, 250, 500, and 1000 hours at 225°C and subsequently evaluated to determine hardness. Three independent groups of samples of Gel 4 are heat aged and evaluated for hardness and the results are shown below in Table 3.

**TABLE 3**

| **Hours at 225°C** | **Gel 4-Test 1** | **Gel 4-Test 2** | **Mean Hardness** |
|---|---|---|---|
| **0** | 34 grams | 36 grams | 35 grams |
| **70** | 30 grams | 31 grams | 31 grams |
| **250** | 26 grams | 27 grams | 27 grams |
| **500** | 36 grams | 40 grams | 38 grams |
| **1000** | 205 grams | 219 grams | 212 grams |

Still additional samples of Gel 4 are further evaluated to determine repeatability of the heat ageing and hardness data developed pursuant to the tests described in detail above. In a first group, samples of Gel 4 are heat aged for 0, 70, 250, 500, and 1000 hours at 250°C and subsequently evaluated to determine hardness. Three independent groups of samples of Gel 4 are heat aged and evaluated for hardness and the results are shown below in Table 4.

**TABLE 4**

| **Hours at 250°C** | **Gel 4-Test 1** | **Gel 4-Test 2** | **Mean Hardness** |
|---|---|---|---|
| **0** | 34 grams | 36 grams | 35 grams |
| **70** | 23 grams | 23 grams | 23 grams |
| **250** | 284 grams | 221 grams | 253 grams |
| **500** | 845 grams | 797 grams | 821 grams |
| **1000** | 1419 grams | 1345 grams | 1382 grams |

The data set forth above establishes that, contrary to conventional wisdom, the hardness of the Gels of this disclosure is low after heat ageing, within standard variances. More specifically, the phthalocyanine in the Gel allows these gels to maintain low modulus properties even after extensive heat ageing.

Two independent batches of the Cu(Pc) are then used to form additional samples of Gel 4 which are further evaluated to determine repeatability of the heat ageing and hardness data developed pursuant to the tests described in detail above. In a first group, a first batch of Cu(Pc) is used to form two samples of Gel 4. One sample is heat aged for 1000 hours at 225°C and a second sample is heat aged for 1000 hours at 250°C. These samples are subsequently evaluated to determine hardness. In a second group, a second batch of Cu(Pc) is used to form two samples of Gel 4. One sample is heat aged for 1000 hours at 225°C and a second sample is heat aged for 1000 hours at 250°C. These samples are subsequently evaluated to determine hardness. The results are set forth below in Table 5.

**TABLE 5**

| **Heat Ageing** | **Gel 4-Batch 1** | **Gel 4-Batch 2** |
|---|---|---|
| **1000 Hours at 225°C** | 28 grams | 219 grams |
| **1000 Hours at 250°C** | 1037 grams | 1345 grams |

The data set forth above establishes that the quality of the (D) phthalocyanine can affect the quality of the results. Accordingly, the variance seen in the data is likely due to the quality of the (D) phthalocyanine and not due to the overall disclosure itself.

To further evaluate the immediately aforementioned results, three additional samples of (D) copper phthalocyanine are subsequently evaluated to determine amounts of various elements (ppm) using an Inductively Coupled Plasma method pursuant to ASTM/UOP 714-07. The results of this elemental analysis are shown below in Table 6. Samples 1 and 2 are 50% by weight masterbatches. Sample 3 is a 40% by weight masterbatch.

**TABLE 6**

| **Element** | **Sample 1 (ppm)** | **Sample 2 (ppm)** | **Sample 3 (ppm)** |
|---|---|---|---|
| Cu | 1626 | 43186 | 40376 |
| Ag | None* | None* | None* |
| Al | 154 | 19 | 19 |
| B | None* | None* | None* |
| Ba | 2 | 11 | 54 |
| Ca | 87 | 163 | 192 |
| Co | None* | None* | None* |
| Cr | 1 | 4 | 5 |
| Fe | 7 | 57 | 76 |
| K | 7 | 15 | 13 |
| Mg | 35 | 44 | 33 |
| Mn | None* | None* | None* |
| Mo | None* | 212 | 179 |
| Na | 72 | 222 | 294 |
| Ni | None* | 5 | 6 |
| P | None* | 25 | 55 |
| Pb | None* | None* | None* |
| Sn | 5 | 70 | 8 |
| Sr | None* | 1 | 1 |
| Ti | None* | 5 | 5 |
| V | 5 | None* | None* |
| Zn | 4 | None* | None* |
| Zr | None* | 2 | None* |

| | | | |
|---|---|---|---|
| * No element was detected in an amount greater than the detection threshold of 1 ppm. | | | |

These samples are then utilized to form additional samples of Gel 4 with increasing amounts of Cu(Pc) up to 1%, as described above. The samples of Gel 4 are then evaluated to determine heat ageing and hardness data developed pursuant to the tests described in detail above. In a first group, Sample 1 of Cu(Pc) is used to form two samples of Gel 4. One sample is heat aged for 1000 hours at 225°C and a second sample is heat aged for 1000 hours at 250°C. These samples are subsequently evaluated to determine hardness. In a second group, Sample 2 of Cu(Pc) is used to form two samples of Gel 4. One sample is heat aged for 1000 hours at 225°C and a second sample is heat aged for 1000 hours at 250°C. In a third group, Sample 3 of Cu(Pc) is used to form two samples of Gel 4. One sample is heat aged for 1000 hours at 225°C and a second sample is heat aged for 1000 hours at 250°C. These samples are subsequently evaluated to determine hardness. The results are shown below in Table 7.

**TABLE 7**

| **Heat Ageing** | **Gel 4- Sample 1** | **Gel 4- Sample 2** | **Gel 4- Sample 3** |
|---|---|---|---|
| **1000 Hours at 225°C** | 906 grams | 30 grams | 36 grams |
| **1000 Hours at 250°C** | 1758 grams | 1115 grams | 1028 grams |
| **Amount of Cu In Sample** | 1626 ppm | 43186 ppm | 40376 ppm |

The data set forth above clearly indicates that increased amounts of copper in the phthalocyanine (in ppm) are correlated with increased effect of the phthalocyanine in improving the thermal stability of the Gels. Said differently, higher amounts of copper in the phthalocyanine result in the Gels having lower hardness after heat ageing.

An additional series of gels (Gels 11-14) are also formed according to this disclosure. Gels 11-14 are formed in accordance with the procedure described above and include 0.1 wt %, 0.5 wt %, 1 wt %, and 5 wt % of Cu(Pc), respectively, and 10 wt % of 200F silicone fluid. After formation, each Gel is heat aged for 1000 hours at 225°C and subsequently evaluated to determine hardness. The results are shown below in Table 8.

**TABLE 8**

| | **Hardness (grams)** |
|---|---|
| **Gel 11 0.1 wt % Cu(Pc)** | 172 grams |
| **Gel 12 0.5 wt % Cu(Pc)** | 28 grams |
| **Gel 13 1 wt % Cu(Pc)** | 22 grams |
| **Gel 14 5 wt % Cu(Pc)** | 16 grams |

Independent samples of Gels 12-14 are also heat aged for 500 hours at 250°C and subsequently evaluated to determine hardness. The results are shown below in Table 9.

**TABLE 9**

| | **Hardness (grams)** |
|---|---|
| **Gel 12 0.5 wt % Cu(Pc)** | 885 grams |
| **Gel 13 1 wt % Cu(Pc)** | 364 grams |
| **Gel 14 5 wt % Cu(Pc)** | 129 grams |

Independent samples of Gel 14 are also heat aged for varying hours, as set forth below, at 225°C or 250°C and subsequently evaluated to determine hardness. The results are shown below in Table 10.

**TABLE 10**

| **Hours Heat Ageing** | **225 °C** | **250 °C** |
|---|---|---|
| **0** | 19 grams | 19 grams |
| **70** | 14 grams | 11 grams |
| **250** | 12 grams | 10 grams |
| **500** | 11 grams | 129 grams |
| **1000** | 16 grams | 882 grams |

The data set forth above again further establishes that, contrary to conventional wisdom, the hardness of the Gels of this disclosure generally decrease after heat ageing, within standard variances. More specifically, the phthalocyanine in the Gel allows these gels to maintain low modulus properties even after extensive heat ageing.

Even further samples of Gels 4 and 14 are evaluated and compared to two additional gels of this disclosure (Gels 15 and 16). As described above, Gels 4 and 14 are formed using 10% of non-reactive silicone fluid and varying amounts Cu(Pc). Gels 15 and 16 are the same as Gels 4 and 14, respectively, except that Gels 15 and 16 do not include any of the non-reactive silicone fluid. Various samples of Gels 4, 14, 15, and 16 are either heated aged for 1000 hrs at 225°C or heat aged at 1000 hrs at 250°C and then evaluated to determine hardness using the method described above. The results are shown below in Table 11:

**TABLE 11**

| **Heat Ageing Parameters** | **Gel 4** | **Gel 14** | **Gel 15** | **Gel 16** |
|---|---|---|---|---|
| **1000 hrs at 225 °C** | 205 grams | 16 grams | 593 grams | 32 grams |
| **1000 hrs at 250 °C** | 1418 grams | 882 grams | 1867 grams | 1282 grams |

The data above even further establishes that, contrary to conventional wisdom, the use of the phthalocyanine and the non-reactive fluid allows these gels to maintain low modulus properties even after extensive heat ageing.

One or more of the values described above may vary by ± 5%, ± 10%, ± 15%, ± 20%, ± 25%, etc. so long as the variance remains within the scope of the disclosure. Unexpected results may be obtained from each member of a Markush group independent from all other members. Each member may be relied upon individually and or in combination and provides adequate support for specific embodiments within the scope of the appended claims. The subject matter of all combinations of independent and dependent claims, both singly and multiply dependent, is herein expressly contemplated. The disclosure is illustrative including words of description rather than of limitation. Many modifications and variations of the present disclosure are possible in light of the above teachings, and the disclosure may be practiced otherwise than as specifically described herein.

## Claims

1. Use of a phthalocyanine (D) in the preparation of a gel to provide said gel with improved thermal stability, the gel being the hydrosilylation reaction product of:
(A) an organopolysiloxane having an average of at least 0.1 silicon-bonded alkenyl group per molecule; and
(B) a cross-linker having an average of at least 2 silicon-bonded hydrogen atoms per molecule;
wherein (A) and (B) react via hydrosilylation in the presence of;
(C) a hydrosilylation catalyst, and
(D) said phthalocyanine present in an amount of from about 0.05 to about 30 weight percent based on a total weight of (A) and (B), and
wherein (A) and (B) optionally react with (E) a silicone fluid in the presence of (C) and (D),
wherein (A) and (B) optionally react in the presence of (C), (D), and (E), and
wherein said gel has a hardness of less than about 1500 grams as measured after heat ageing at 225°C for 1000 hours that is calculated as a weight required to insert a TA-23 probe into said gel to a depth of 3 mm; and
wherein said gel is free of a reinforcing filler.

2. Use of a phthalocyanine (D) in the preparation of a gel as set forth in claim 1 wherein said (D) phthalocyanine or a halogen salt thereof comprises a metal.

3. Use of a phthalocyanine (D) in the preparation of a gel as set forth in claim 2 wherein said metal is a transition metal.

4. Use of a phthalocyanine (D) in the preparation of a gel as set forth in claim 2 wherein said metal is selected from the group consisting of iron, magnesium, cobalt, and copper.

5. Use of a phthalocyanine (D) in the preparation of a gel as set forth in claim 2 wherein said halogen salt is further defined as phthalocyanine chloride and comprises said metal.

6. Use of a phthalocyanine (D) in the preparation of a gel as set forth in claim 4 wherein said (D) phthalocyanine is selected from the group consisting of (29H,31H-phthalocyaninato(2-)-N29,N30,N31,N32)Iron; (29H,31H-phthalocyaninato(2-)-N29,N30,N31,N32)Magnesium; (29H,31H-phthalocyaninato(2-)-N29,N30,N31,N32)Cobalt, and (29H,31H-phthalocyaninato(2-)-N29,N30,N31,N32)Copper.

7. Use of a phthalocyanine (D) in the preparation of aA gel as set forth in claim 1 wherein (E) is further defined as a functional silicone fluid, said hydrosilylation reaction product is further defined as a hydrosilylation reaction product of (A), (B), and (E), and (A), (B), and (E) react via hydrosilylation in the presence of (C) and (D).

8. Use of a phthalocyanine (D) in the preparation of a gel as set forth in claim 1 wherein the hardness initially decreases after heat ageing.

9. Use of a phthalocyanine (D) in the preparation of a gel as set forth in claim 2 wherein said (D) phthalocyanine comprises at least 40,000 ppm of a metal based on a total weight of said gel as determined using inductively coupled plasma and ASTM/UOP 714-07.

10. Use of a phthalocyanine (D) in the preparation of a gel as set forth in claim 1 having a hardness of less than 40 grams that initially decreases after heat ageing, wherein said phthalocyanine is present in an amount of from 0.1 to 2 weight percent based on a total weight of (A) and (B) and comprises a metal selected from the group consisting of iron, magnesium, cobalt, and copper, and wherein (A) and (B) are present in an amount such that a ratio of silicon-bonded hydrogen atoms to silicon-bonded alkenyl groups is less than about 1.3:1.

11. Use of a phthalocyanine (D) in the preparation of a gel as set forth in claim 1 in an electronic article comprising an electronic component and a gel prepared according to any of claims 1 to 10.

12. Use of a phthalocyanine (D) in the preparation of a gel as set forth in claim 1 in an insulated gate bipolar transistor comprising a chip and a gel prepared according to any of claims 1 to 10, wherein said gel encapsulates said chip.

13. Use of a phthalocyanine (D) in the preparation of a gel according to claim 1 wherein said phthalocyanine is present in an amount of from 0.1 to 1 weight percent based on a total weight of (A) and (B).

14. Use of a phthalocyanine (D) in the preparation of a gel according to claim 1 wherein (A) and (B) react via hydrosilylation in the presence of (C), (D), and (E) a non-functional silicone fluid.

15. Use of a phthalocyanine (D) in the preparation of a gel as set forth in claim 1 in an electronic article according to claim 11 wherein said gel encapsulates said electronic component.

## Patentansprüche

1. Eine Verwendung eines Phthalocyanins (D) bei der Herstellung eines Gels, um dem Gel eine verbesserte thermische Stabilität bereitzustellen, wobei das Gel das Hydrosilylierungsreaktionsprodukt von Folgendem ist:
(A) einem Organopolysiloxan mit einem Durchschnitt von mindestens 0,1 siliciumgebundener Alkenylgruppe pro Molekül; und
(B) einem Vernetzer mit einem Durchschnitt von mindestens 2 siliciumgebundenen Wasserstoffatomen pro Molekül;
wobei (A) und (B) durch Hydrosilylierung in Gegenwart von Folgendem reagieren:
(C) einem Hydrosilylierungskatalysator, und
(D) dem Phthalocyanin, das in einer Menge von etwa 0,05 bis etwa 30 Gewichtsprozent, bezogen auf ein Gesamtgewicht von (A) und (B) vorhanden ist, und
wobei (A) und (B) optional mit (E) einem Siliconfluid in Gegenwart von (C) und (D) reagieren,
wobei (A) und (B) optional in Gegenwart von (C), (D) und (E) reagieren, und
wobei das Gel eine Härte von weniger als etwa 1 500 Gramm aufweist, wie gemessen nach Wärmealterung für 1 000 Stunden bei 225 °C, die berechnet wird als ein Gewicht, das erforderlich ist, um eine TA-23-Sonde bis zu einer Tiefe von 3 mm in das Gel einzuführen; und
wobei das Gel frei von einem Verstärkerfüllstoff ist.

2. Verwendung eines Phthalocyanins (D) bei der Herstellung eines Gels gemäß Anspruch 1, wobei das (D) Phthalocyanin oder ein Halogensalz davon ein Metall beinhaltet.

3. Verwendung eines Phthalocyanins (D) bei der Herstellung eines Gels gemäß Anspruch 2, wobei das Metall ein Übergangsmetall ist.

4. Verwendung eines Phthalocyanins (D) bei der Herstellung eines Gels gemäß Anspruch 2, wobei das Metall aus der Gruppe, bestehend aus Eisen, Magnesium, Kobalt und Kupfer, ausgewählt ist.

5. Verwendung eines Phthalocyanins (D) bei der Herstellung eines Gels gemäß Anspruch 2, wobei das Halogensalz ferner als Phthalocyaninchlorid definiert ist und das Metall beinhaltet.

6. Verwendung eines Phthalocyanins (D) bei der Herstellung eines Gels gemäß Anspruch 4, wobei das (D) Phthalocyanin ausgewählt ist aus der Gruppe, bestehend aus (29H,31H-Phthalocyaninato(2-)-N29,N30,N31,N32)eisen; (29H,31H-Phthalocyaninato(2-)-N29,N30,N31,N32)magnesium; (29H,31H-Phthalocyaninato(2-)-N29,N30,N31,N32)kobalt und (29H,31H-Phthalocyaninato(2-)-N29,N30,N31,N32)kupfer.

7. Verwendung eines Phthalocyanins (D) bei der Herstellung eines Gels gemäß Anspruch 1, wobei (E) ferner als ein funktionelles Siliconfluid definiert ist, wobei das Hydrosilylierungsreaktionsprodukt ferner als ein Hydrosilylierungsreaktionsprodukt von (A), (B) und (E) definiert ist und (A), (B) und (E) in Gegenwart von (C) und (D) durch Hydrosilylierung reagieren.

8. Verwendung eines Phthalocyanins (D) bei der Herstellung eines Gels gemäß Anspruch 1, wobei die Härte anfänglich nach Wärmealterung abnimmt.

9. Verwendung eines Phthalocyanins (D) bei der Herstellung eines Gels gemäß Anspruch 2, wobei das (D) Phthalocyanin mindestens 40 000 ppm eines Metalls, bezogen auf ein Gesamtgewicht des Gels, wie unter Verwendung von induktiv gekoppeltem Plasma und ASTM/UOP 714-07 bestimmt, beinhaltet.

10. Verwendung eines Phthalocyanins (D) bei der Herstellung eines Gels gemäß Anspruch 1 mit einer Härte von weniger als 40 Gramm, die anfänglich nach Wärmealterung abnimmt, wobei das Phthalocyanin in einer Menge von 0,1 bis 2 Gewichtsprozent, bezogen auf ein Gesamtgewicht von (A) und (B), vorhanden ist und ein Metall, das ausgewählt ist aus der Gruppe, bestehend aus Eisen, Magnesium, Kobalt und Kupfer, beinhaltet, und wobei (A) und (B) in einer Menge vorhanden sind, sodass ein Verhältnis von siliciumgebundenen Wasserstoffatomen zu siliciumgebundenen Alkenylgruppen weniger als etwa 1,3 : 1 beträgt.

11. Verwendung eines Phthalocyanins (D) bei der Herstellung eines Gels gemäß Anspruch 1 in einem elektronischen Artikel, beinhaltend eine elektronische Komponente und ein gemäß einem der Ansprüche 1 bis 10 hergestelltes Gel.

12. Verwendung eines Phthalocyanins (D) bei der Herstellung eines Gels gemäß Anspruch 1 in einem Bipolartransistor mit isoliertem Gate, beinhaltend einen Chip und ein Gel, hergestellt gemäß einem der Ansprüche 1 bis 10, wobei das Gel den Chip einkapselt.

13. Verwendung eines Phthalocyanins (D) bei der Herstellung eines Gels gemäß Anspruch 1, wobei das Phthalocyanin in einer Menge von 0,1 bis 1 Gewichtsprozent, bezogen auf ein Gesamtgewicht von (A) und (B), vorhanden ist.

14. Verwendung eines Phthalocyanins (D) bei der Herstellung eines Gels gemäß Anspruch 1, wobei (A) und (B) in Gegenwart von (C), (D) und (E) einem nichtfunktionellen Siliconfluid durch Hydrosilylierung reagieren.

15. Verwendung eines Phthalocyanins (D) bei der Herstellung eines Gels gemäß Anspruch 1 in einem elektronischen Artikel gemäß Anspruch 11, wobei das Gel die elektronische Komponente einkapselt.

## Revendications

1. Utilisation d'une phtalocyanine (D) dans la préparation d'un gel afin de fournir audit gel une stabilité thermique améliorée, le gel étant le produit de réaction d'hydrosilylation :
(A) d'un organopolysiloxane ayant une moyenne d'au moins 0,1 groupe alcényle lié au silicium par molécule ; et
(B) d'un agent réticulant ayant une moyenne d'au moins 2 atomes d'hydrogène liés au silicium par molécule ;
dans laquelle (A) et (B) réagissent par l'intermédiaire d'une hydrosilylation en présence :
(C) d'un catalyseur d'hydrosilylation, et
(D) de ladite phtalocyanine présente dans une quantité allant d'environ 0,05 à environ 30 pour cent en poids rapporté à un poids total de (A) et (B), et
dans laquelle (A) et (B) réagissent facultativement avec (E) un fluide de silicone en présence de (C) et (D),
dans laquelle (A) et (B) réagissent facultativement en présence de (C), (D), et (E), et
dans laquelle ledit gel a une dureté de moins d'environ 1 500 grammes telle que mesurée après vieillissement à la chaleur à 225 °C pendant 1 000 heures qui est calculée comme un poids requis pour insérer une sonde TA-23 dans ledit gel jusqu'à une profondeur de 3 mm ; et
dans laquelle ledit gel est dépourvu de charge renforçante.

2. Utilisation d'une phtalocyanine (D) dans la préparation d'un gel telle qu'énoncée dans la revendication 1 dans laquelle ladite (D) phtalocyanine ou un sel halogéné de celle-ci comprend un métal.

3. Utilisation d'une phtalocyanine (D) dans la préparation d'un gel telle qu'énoncée dans la revendication 2 dans laquelle ledit métal est un métal de transition.

4. Utilisation d'une phtalocyanine (D) dans la préparation d'un gel telle qu'énoncée dans la revendication 2 dans laquelle ledit métal est sélectionné dans le groupe constitué du fer, du magnésium, du cobalt, et du cuivre.

5. Utilisation d'une phtalocyanine (D) dans la préparation d'un gel telle qu'énoncée dans la revendication 2 dans laquelle ledit sel halogéné est défini en sus comme un chlorure de phtalocyanine et comprend ledit métal.

6. Utilisation d'une phtalocyanine (D) dans la préparation d'un gel telle qu'énoncée dans la revendication 4 dans laquelle ladite (D) phtalocyanine est sélectionnée dans le groupe constitué du (29H,31H-phtalocyaninato(2-)-N29,N30,N31,N32)fer ; du (29H,31H-phtalocyaninato(2-)-N29,N30,N31,N32)magnésium ; du (29H,31H-phtalocyaninato(2-)-N29,N30,N31,N32)cobalt, et du (29H,31H-phtalocyaninato(2-)-N29,N30,N31,N32)cuivre.

7. Utilisation d'une phtalocyanine (D) dans la préparation d'un gel telle qu'énoncée dans la revendication 1 dans laquelle (E) est défini en sus comme un fluide de silicone fonctionnel, ledit produit de réaction d'hydrosilylation est défini en sus comme un produit de réaction d'hydrosilylation de (A), (B), et (E), et (A), (B), et (E) réagissent par l'intermédiaire d'une hydrosilylation en présence de (C) et (D).

8. Utilisation d'une phtalocyanine (D) dans la préparation d'un gel telle qu'énoncée dans la revendication 1 dans laquelle la dureté diminue initialement après vieillissement à la chaleur.

9. Utilisation d'une phtalocyanine (D) dans la préparation d'un gel telle qu'énoncée dans la revendication 2 dans laquelle ladite (D) phtalocyanine comprend au moins 40 000 ppm d'un métal rapporté à un poids total dudit gel tel que déterminé à l'aide d'un plasma inductif et de l'ASTM/UOP 714-07.

10. Utilisation d'une phtalocyanine (D) dans la préparation d'un gel telle qu'énoncée dans la revendication 1 ayant une dureté de moins de 40 grammes qui diminue initialement après vieillissement à la chaleur, dans laquelle ladite phtalocyanine est présente dans une quantité allant de 0,1 à 2 pour cent en poids rapporté à un poids total de (A) et (B) et comprend un métal sélectionné dans le groupe constitué du fer, du magnésium, du cobalt, et du cuivre, et dans laquelle (A) et (B) sont présents dans une quantité telle qu'un rapport des atomes d'hydrogène liés au silicium aux groupes alcényle liés au silicium soit de moins d'environ 1,3/1.

11. Utilisation d'une phtalocyanine (D) dans la préparation d'un gel telle qu'énoncée dans la revendication 1 dans un article électronique comprenant un composant électronique et un gel préparé selon n'importe lesquelles des revendications 1 à 10.

12. Utilisation d'une phtalocyanine (D) dans la préparation d'un gel telle qu'énoncée dans la revendication 1 dans un transistor bipolaire à porte isolée comprenant une puce et un gel préparé selon n'importe lesquelles des revendications 1 à 10, dans laquelle ledit gel encapsule ladite puce.

13. Utilisation d'une phtalocyanine (D) dans la préparation d'un gel selon la revendication 1 dans laquelle ladite phtalocyanine est présente dans une quantité allant de 0,1 à 1 pour cent en poids rapporté à un poids total de (A) et (B).

14. Utilisation d'une phtalocyanine (D) dans la préparation d'un gel selon la revendication 1 dans laquelle (A) et (B) réagissent par l'intermédiaire d'une hydrosilylation en présence de (C), (D), et (E) un fluide de silicone non fonctionnel.

15. Utilisation d'une phtalocyanine (D) dans la préparation d'un gel telle qu'énoncée dans la revendication 1 dans un article électronique selon la revendication 11 dans laquelle ledit gel encapsule ledit composant électronique.
